# EUROPEAN PATENT APPLICATION

(11) **EP 4 590 083 A1**
(43) Date of publication of application: **23.07.2025**
(21) Application number: 24191441.5
(22) Date of filing: 29.07.2024
(51) Int. Cl.: H10B 12/00

(54) **CAPACITOR STRUCTURE, SEMICONDUCTOR DEVICE INCLUDING SAME, AND METHOD OF MANUFACTURING CAPACITOR STRUCTURE**

(30) Priority: 16.01.2024 KR 20240006983
(71) Applicant: SAMSUNG ELECTRONICS CO., LTD., Yeongtong-gu Suwon-si, Gyeonggi-do 16677 (KR)
(72) Inventor: CHO, Chunhum, 16677 Suwon-si, Gyeonggi-do (KR); BAEK, Dongkwan, 16677 Suwon-si, Gyeonggi-do (KR); CHANG, Jaewan, 16677 Suwon-si, Gyeonggi-do (KR); KIM, Hyunbin, 16677 Suwon-si, Gyeonggi-do (KR); LEE, Junseok, 16677 Suwon-si, Gyeonggi-do (KR)
(74) Representative: Kuhnen & Wacker Patent- und Rechtsanwaltsbüro PartG mbB

(57) **Abstract**

The present disclosure relates to a capacitor structure CS, a semiconductor device 100 including the same, and a manufacturing method for a capacitor structure CS. Implementations of the present disclosure provide a capacitor structure CS including: a plurality of lower electrodes 170 positioned on a substrate 110; a supporter 190 positioned between sidewalls of the lower electrodes 170 and extending in a direction parallel to an upper surface of the substrate 110; an auxiliary layer 300 disposed on the plurality of lower electrodes 170; a dielectric layer 180 disposed on the auxiliary layer 300 and the supporter 190; and an upper electrode 200 positioned on the dielectric layer 180. The auxiliary layer 300 includes a first auxiliary layer 310 including a conductive first material and also includes a second auxiliary layer 320 including an insulating second material.

## Description

### BACKGROUND

With down-scaling of semiconductor devices, a space occupied by a capacitor structure is shrinking. Accordingly, there is a need to develop a capacitor structure that can overcome spatial limitations and design rule limitations and maintain desired electrical characteristics while increasing capacitance.

### SUMMARY

The present disclosure relates to capacitor structures, semiconductor devices including the same, and manufacturing methods for capacitor structures. Implementations disclosed herein may improve operating characteristics of a semiconductor device including a capacitor and reduce bridge disturbance.

Implementations of the present disclosure provide a capacitor structure including: a plurality of lower electrodes positioned on a substrate; a supporter positioned between sidewalls of the lower electrodes and extending in a direction parallel to an upper surface of the substrate; an auxiliary layer disposed on the plurality of lower electrodes; a dielectric layer disposed on the auxiliary layer and the supporter; and an upper electrode positioned on the dielectric layer, wherein the auxiliary layer includes: a first auxiliary layer including a conductive first material; and a second auxiliary layer including an insulating second material.

Implementations of the present disclosure provide a semiconductor device including: an active pattern positioned on a substrate; a gate structure extending in a first direction parallel to an upper surface of the substrate and buried in an upper portion of the substrate; a bit line structure extending in a second direction parallel to the upper surface of the substrate and to intersect the active pattern; a contact plug structure connected to an end portion of the active pattern; and a capacitor structure connected to the contact plug structure, wherein the capacitor structure includes: a plurality of lower electrodes positioned on the substrate; a supporter positioned between sidewalls of the lower electrodes and extending in a direction parallel to an upper surface of the substrate; an auxiliary layer disposed on the lower electrodes; a dielectric layer disposed on the auxiliary layer and the supporter; and an upper electrode positioned on the dielectric layer, wherein the auxiliary layer includes: a first auxiliary layer including a first metal; and a second auxiliary layer including a second metal.

An amount of the first metal on a surface of the supporter may be less than 10 % of an amount of the first metal on a surface of the plurality of lower electrodes. An amount of the first metal on the surface of the supporter may be above than 0 % of the amount of the first metal on the surface of the plurality of lower electrodes. The plurality of lower electrodes, the first auxiliary layer, the second auxiliary layer, and the dielectric layer may be positioned in that order. The plurality of lower electrodes, the second auxiliary layer, the first auxiliary layer, and the dielectric layer may be positioned in that order.

Implementations of the present disclosure provide a manufacturing method for a capacitor structure including: providing a supporter positioned between a plurality of lower electrodes positioned on a substrate and sidewalls of the lower electrodes and extending in a direction parallel to an upper surface of the substrate; forming a first auxiliary layer including a first material covering a surface of the lower electrodes and the supporter; forming a second auxiliary layer including a second material on the first auxiliary layer; performing heat treatment on a structure on which the second auxiliary layer is formed; selectively removing a portion of the first auxiliary layer and a portion of the second auxiliary layer positioned on the supporter by etching the first material; and depositing a dielectric layer, wherein the first auxiliary layer and the second auxiliary layer are disposed between the lower electrode and the dielectric layer, and the dielectric layer is disposed directly on the supporter.

According to some implementations, it may be possible to provide a capacitor structure, a semiconductor device including the same, and a manufacturing method for a capacitor structure, capable of improving operating characteristics of a semiconductor device including a capacitor and reducing bridge disturbance.

### BRIEF DESCRIPTION OF THE DRAWINGS

FIG. 1 illustrates a layout diagram showing a semiconductor device according to some implementations.
FIG. 2 illustrates a cross-sectional view taken along a line I-I' of FIG. 1.
FIG. 3 illustrates an enlarged view of a region P1 of FIG. 2 to show a capacitor structure according to some implementations.
FIG. 4 illustrates an enlarged view of the region P1 of FIG. 2 to show a capacitor structure according to some implementations.
FIG. 5 illustrates enlarged views of a region P2 of FIG. 3 to show a first auxiliary layer according to various some implementations.
FIG. 6 to FIG. 16 illustrate cross-sectional views showing a manufacturing method for a capacitor structure according to some implementations.

### DETAILED DESCRIPTION

The present disclosure will be described more fully hereinafter with reference to the accompanying drawings, in which implementations of the disclosure are shown. As those skilled in the art would realize, the described implementations may be modified in various different ways, all without departing from the scope of the present disclosure.

To clearly describe the present implementation, parts that are irrelevant to the description are omitted, and like numerals refer to like or similar components throughout the specification.

Further, since sizes and thicknesses of constituent members shown in the accompanying drawings are arbitrarily given for better understanding and ease of description, the present disclosure is not limited to the illustrated sizes and thicknesses. In the drawings, the thicknesses of layers, films, panels, regions, etc., are exaggerated for clarity. In the drawings, for better understanding and ease of description, the thicknesses of some layers and areas are exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, in the specification, the word "on" or "above" means positioned on or below the object portion and does not necessarily mean positioned on the upper side of the object portion based on a gravitational direction.

In addition, unless explicitly described to the contrary, the word "comprise" and variations such as "comprises" or "comprising" will be understood to imply the inclusion of stated elements but not the exclusion of any other elements.

Further, throughout the specification, the phrase "in a plan view" means when an object portion is viewed from above, and the phrase "in a cross-sectional view" means when a cross-section taken by vertically cutting an object portion is viewed from the side.

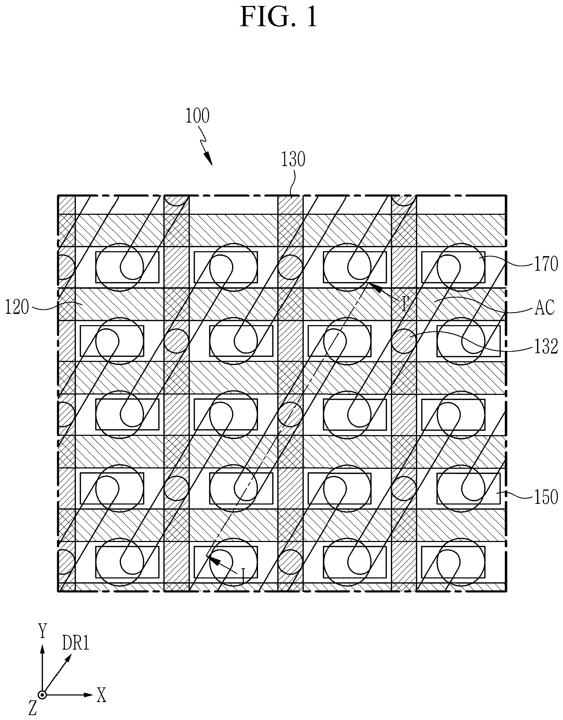

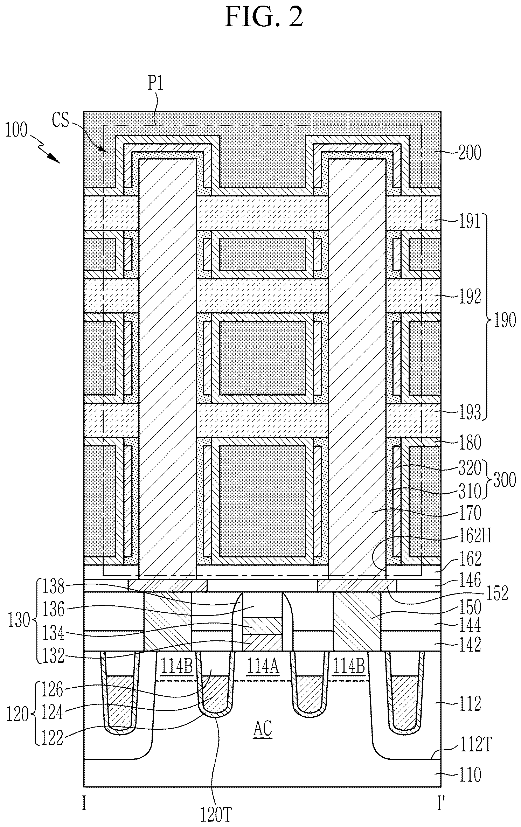

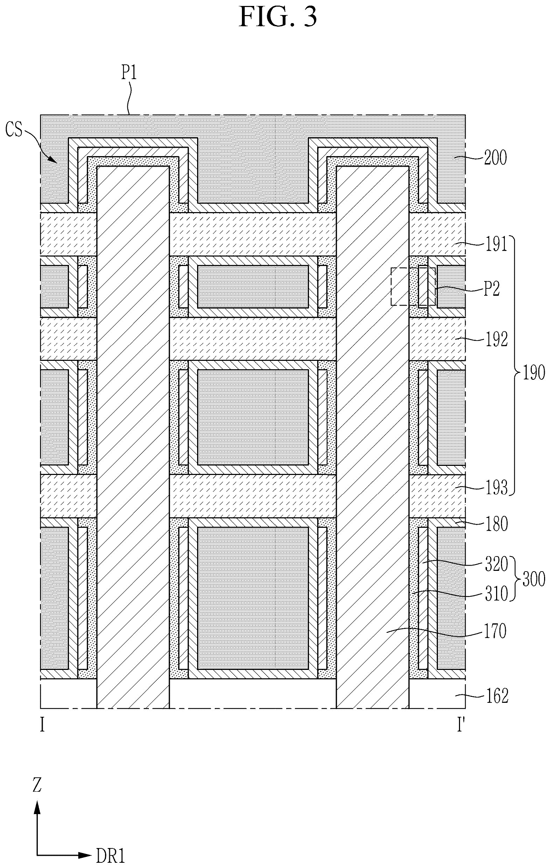

FIG. 1 illustrates a layout diagram showing a semiconductor device 100 according to some implementations. FIG. 2 illustrates a cross-sectional view taken along a line I-I' of FIG. 1. FIG. 3 illustrates an enlarged view of a region P1 of FIG. 2 to show a capacitor structure CS according to some implementations.

Referring to FIG. 1 and FIG. 2, the semiconductor device 100 according to some implementations may include a substrate 110, an active pattern AC positioned on the substrate 110, a gate structure 120 overlapping the active pattern AC, a bit line structure 130 connected to the active pattern (AC) on a first side of the gate structure 120, a contact plug structure 150 connected to the active pattern AC on a second side of the gate structure 120, and a capacitor structure CS connected to the contact plug structure 150.

The substrate 110 may include a semiconductor material such as Si, Ge, SiGe, SiC, GaAs, InAs, or InP. However, a material included in the substrate 110 is not limited thereto and may be variously changed.

In addition, the substrate 110 may include a conductive region, e.g., a well doped with impurities or a structure doped with impurities.

A device isolation layer 112 may have a shallow trench isolation (STI) structure. For example, the device isolation layer 112 may include an insulating material that fills a device isolation trench 112T formed in the substrate 110.

The insulating material may include fluoro-silicate glass (FSG), undoped silicate glass (USG), boro-phospho-silicate glass (BPSG), phospho-silicate glass (PSG), flowable oxide (FOX), and plasma enhanced tetra-ethyl-ortho-silicate (PE-TEOS), or polysilazane (e.g., TOSZ), but the present disclosure is not limited thereto, and it may be changed in various ways.

The active pattern AC may be defined by the device isolation layer 112. The active pattern AC may be positioned on the substrate 110.

The active pattern (AC) may have a bar shape with a minor axis and a major axis in a plan view. As illustrated in FIG. 1, the major axis of the active pattern AC may be arranged along a diagonal direction DR1 parallel to an upper surface of the substrate 110. The active pattern AC may be doped with P-type or N-type impurities.

A gate line trench 120T may intersect the active pattern AC and may be formed to a predetermined depth in a vertical third direction (Z direction) from the upper surface of the substrate 110. A portion of the gate line trench 120T may extend into the device isolation layer 112, and a portion of the gate line trench 120T formed in the device isolation layer 112 may have a bottom surface positioned at a lower level than a portion of the gate line trench 120T formed in the active pattern AC.

A first source/drain region 114A and a second source/drain region 114B may be positioned in an upper region of the active pattern AC positioned on both sides of the gate line trench 120T. The first source/drain region 114A and the second source/drain region 114B may be positioned on both sides with the gate line trench 120T provided therebetween.

The first source/drain region 114A and the second source/drain region 114B may be regions doped with impurities of a different conductivity type from that of impurities doped in the active pattern AC. For example, the first source/drain region 114A and the second source/drain region 114B may be doped with N-type or P-type impurities.

The gate structure 120 may be positioned inside the gate line trench 120T. The gate structure 120 may extend in a first direction (X direction) parallel to the upper surface of the substrate 110 and may be buried in an upper portion of the substrate 110. The gate structure 120 may include a gate insulating layer 122, a gate electrode 124, and a gate capping layer 126 sequentially positioned on an inner wall surface of the gate line trench 120T.

The gate insulation layer 122 may be positioned conformally on the interior wall of the gate line trench 120T.

For example, the gate insulating layer 122 may be formed of HfO₂, ZrO₂, Al₂O₃, HfAlO₃, Ta₂O₃, TiO₂, or a combination thereof. However, a material included in the gate insulating layer 122 is not limited thereto and may be variously changed.

The gate electrode 124 may be positioned on the gate insulating layer 122.

The gate electrode 124 may extend from a bottom portion of the gate line trench 120T toward the vertical third direction (Z direction) and may fill a portion of the gate line trench 120T.

The gate electrode 124 may include a work function adjustment layer (not shown) disposed on the gate insulating layer 122 and a buried metal layer (not shown) that fills the bottom portion of the gate line trench 120T above the work function adjustment layer. For example, the work function adjustment layer may include a metal such as Ti, TiN, TiAlN, TiAlC, TiAlCN, TiSiCN, Ta, TaN, TaAlN, TaAlCN, TaSiCN, a metal nitride, or a metal carbide, and the buried metal layer may include at least one of W, WN, TiN, or TaN. However, a material included in the gate electrode 124 is not limited thereto and may be variously changed.

The gate capping layer 126 may be positioned on the gate electrode 124 and may fill a remaining region within the gate line trench 120T after the gate electrode 124 was formed. For example, the gate capping layer 126 may include at least one of a silicon oxide, a silicon nitride, or a silicon oxynitride. However, a material included in the gate capping layer 126 is not limited thereto and may be variously changed.

A bit line structure 130 may be positioned parallel to the upper surface of the substrate 110 and extending along a second direction (Y direction) perpendicular to the first direction (X direction) on the first source/drain area 114A. The bit line structure 130 may be positioned on a central portion of the active pattern AC. The bit line structure 130 may be connected to the central portion of the active pattern AC.

The bit line structure 130 may include a bit line contact 132, a bit line 134, a bit line capping layer 136, and a bit line spacer 138 sequentially stacked on the substrate 110.

The bit line contact 132 may connect the bit line 134 and the first source/drain region 114A. The bit line contact 132 may be positioned between the bit line 134 and the first source/drain region 114A. The bit line contact 132 may be positioned at an overlap portion between the bit line 134 and the first source/drain region 114A in a plan view.

In some implementations, a bit line intermediate layer (not shown) may be provided between the bit line contact 132 and the bit line 134. For example, the bit line intermediate layer may include a metal silicide, such as a tungsten silicide, or a metal nitride, such as a tungsten nitride.

In FIG. 1, the bit line contact 132 is shown as a circle in a plan view, but the present disclosure is not limited thereto, and the plan shape of the bit line contact 132 may be changed in various ways.

The bit line contact 132 and the bit line 134 may include a conductive material. For example, the bit line contact 132 may include polysilicon, and the bit line 134 may include a metal material. However, materials included in the bit line contact 132 and the bit line 134 are not limited thereto and may change in various ways.

The bit line capping layer 136 may be disposed on the bit line 134. The bit line capping layer 136 may cover an upper surface of the bit line 134.

The bit line capping layer 136 may include an insulating material such as a silicon nitride or a silicon oxynitride. However, a material included in the bit line capping layer 136 is not limited thereto and may be variously changed.

The bit line spacer 138 may cover a side surface of the bit line contact 132, a side surface of the bit line 134, and a side surface of the bit line capping layer 136 and may extend in a third direction (Z direction) perpendicular to the substrate 110. The upper surface of the bit line spacer 138 may include a curved surface. A lower surface of the bit line spacer 138 may contact the first source/drain region 114A and the gate insulating layer 122.

In FIG. 2, the bit line spacer 138 is illustrated as being made of a single layer, but the present disclosure is not limited thereto, and in some implementations, the bit line spacer 138 may be made of multiple layers including a plurality of insulating layers. Additionally, in some implementations, the bit line spacer 138 may further include an air spacer (not shown).

The bit line spacer 138 may include an insulating material such as a silicon oxide, a silicon nitride, a silicon oxynitride, or a combination thereof. However, a material included in the bit line spacer 138 is not limited thereto and may be variously changed.

In FIG. 2, the bit line contact 132 is shown as being formed to have a bottom surface at the same level as the upper surface of the substrate 110, but in contrast, a recess may be formed at a predetermined depth from the upper surface of the substrate 110 and the bit line contact 132 may extend inside the recess, so that the bottom surface of the bit line contact 132 is formed at a lower level than the upper surface of the substrate 110.

A first insulating layer 142 and a second insulating layer 144 may be sequentially stacked on the substrate 110, and the bit line structure 130 may extend through the first insulating layer 142 and the second insulating layer 144 to be connected to the first source/drain region 114A.

The contact plug structure 150 may be positioned on the substrate 110. The contact plug structure 150 may be positioned on the second source/drain region 114B. The contact plug structure 150 may electrically connect the second source/drain region 114B and a landing pad 152, which will be described later.

The contact plug structure 150 may be positioned on an end portion of the active pattern AC. The contact plug structure 150 may be connected to the end portion of the active pattern AC. Herein, the end portion of the active pattern AC may be positioned at opposite sides of the central portion of the active pattern AC along a major axis direction of the active pattern AC.

A side surface of the contact plug structure 150 may be surrounded by the first insulating layer 142 and the second insulating layer 144. The side surface of the contact plug structure 150 may be in contact with the first insulating layer 142 and the second insulating layer 144.

In some implementations, the contact plug structure 150 may include a lower contact pattern (not shown) and a metal silicide layer (not shown) sequentially stacked on the substrate 110, and an upper contact pattern (not shown) and a barrier layer (not shown) surrounding side and bottom surfaces of an upper contact pattern.

Additionally, in some implementations, the lower contact pattern may include polysilicon and the upper contact pattern may include a metal material. The barrier layer may include a conductive metal nitride. However, any material included in each of the lower contact pattern, the upper contact pattern, and the barrier layer is not limited thereto, and may vary in various ways.

A third insulating layer 146 may be positioned on the second insulating layer 144. A landing pad 152 extending through the third insulating layer 146 may be positioned on the contact plug structure 150. The landing pad 152 may electrically connect the contact plug structure 150 and the capacitor structure CS to be described later.

The landing pad 152 may overlap the entire upper surface of the contact plug structure 150 in the third direction (Z direction) and may have a larger width than the contact plug structure 150. Accordingly, the landing pad 152 may be in contact with the contact plug structure 150 and the second insulating layer 144.

The landing pad 152 may include at least one of a metal such as ruthenium (Ru), titanium (Ti), tantalum (Ta), niobium (Nb), iridium (Ir), molybdenum (Mo), or tungsten (W), or a conductive metal nitride such as a titanium nitride (TiN), a tantalum nitride (TaN), a niobium nitride (NbN), a molybdenum nitride (MoN), or a tungsten nitride (WN). Additionally, in some implementations, the landing pad 152 may include a titanium nitride (TiN). However, a material included in the landing pad 152 is not limited thereto and may be variously changed.

An etch stop layer 162 may be positioned on the landing pad 152 and the third insulating layer 146. The etch stop layer 162 may include an etch stop layer opening 162H that overlaps at least a portion of the landing pad 152.

The etch stop layer 162 may include a material that has etch selectivity with respect to mold layers containing an oxide. At least a portion of the mold layers may be etched to form the capacitor structure CS to be described later. The etch stop layer 162 may include, e.g., a silicon nitride (SiN), a silicon carbonitride (SiCN), a silicon boronitride (SiBN), a silicon carbonate (SiCO), a silicon oxynitride (SiON), a silicon carbonate nitride (SiOCN), or a combination thereof. However, a material included in the etch stop layer 162 is not limited thereto and may be variously changed.

The capacitor structure CS may be positioned on the etch stop layer 162. Hereinafter, the capacitor structure CS will be described with further reference to FIG. 3. Referring to FIG. 3, the capacitor structure CS according to some implementations may include a plurality of lower electrodes 170, a supporter 190 positioned between the plurality of lower electrodes 170, an auxiliary layer 300 disposed on the lower electrodes 170, a dielectric layer 180 disposed on the auxiliary layer 300 and the supporter 190, and an upper electrode 200 positioned on the dielectric layer 180.

The lower electrode 170 may be electrically connected to the contact plug structure 150 with the landing pad 152 provided therebetween. As illustrated in FIG. 1, the lower electrodes 170 and the contact plug structures 150 may be repeatedly arranged along the first direction (X direction) and the second direction (Y direction). Although not illustrated in FIG. 1, the landing pad 152 may overlap the lower electrode 170 in the third direction (Z direction) and may be spaced apart in the first direction (X direction) and the second direction (Y direction) to be arranged in a matrix shape. However, the present disclosure is not limited thereto, and in some implementations, the contact plug structures 150 may be repeatedly arranged along the first direction (X direction) and the second direction (Y direction), but the lower electrodes 170 may be arranged in a hexagonal shape such as a honeycomb structure. In this case, the landing pad 152 may be arranged to overlap a portion of the contact plug structure 150 in the third direction (Z direction), while overlapping the entire lower electrode 170 in the third direction (Z direction).

In addition, as illustrated in FIG. 1, the lower electrode 170 may be circular in plan, but the present disclosure is not limited thereto, and in some implementations, a planar shape of the lower electrode 170 may be oval, or various polygons such as a square, a rounded square, a diamond, a trapezoid, etc., and various rounded polygons.

The lower electrode 170 may be positioned on the landing pad 152, and a bottom surface of the lower electrode 170 may be positioned within the etch stop layer opening 162H. A width of the bottom surface of the lower electrode 170 may be smaller than a width of the landing pad 152, and thus the entire bottom surface of the lower electrode 170 may be in contact with the landing pad 152.

The supporter 190 may surround the lower electrode 170 and may be positioned on a side surface of the lower electrode 170. The supporter 190 may include a first supporter 191, a second supporter 192, and a third supporter 193 that are positioned spaced apart in the third direction (Z direction).

The supporter 190 may be positioned between the lower electrode 170 and another lower electrode 170 adjacent thereto. The lower electrode 170 may have a narrow and thick shape and may fall or collapse due to this shape. The supporter 190 may function as a support member that prevents the lower electrode 170 from falling or collapsing.

The first supporter 191 may be positioned to surround a side surface of the upper region of the lower electrode 170, and the third supporter 193 may be positioned to surround a side surface of the lower region of the lower electrode 170. The second supporter 192 may be positioned between the first supporter 191 and the third supporter 193.

In FIG. 2, a number of supporters 190 positioned on the side surface of the lower electrode 170 is shown to be three, but the number and arrangement of the supporters 190 are not limited thereto. For example, some of the first supporter 191, the second supporter 192, and the third supporter 193 may be omitted, or the supporter 190 may include an additional supporter positioned between the first supporter 191, the second supporter 192, and the third supporter 193.

The supporter 190 may have a thickness in the third direction (Z direction). A thickness of the first supporter 191, a thickness of the second supporter 192, and a thickness of the third supporter 193 may be substantially the same, but the present disclosure is not limited thereto, and the thicknesses of the first supporter 191 to the third supporter 193 may be changed in various ways.

The supporter 190 may include a silicon nitride, a silicon oxynitride, a silicon boron nitride (SiBN), or a silicon carbonitride (SiCN). However, the present disclosure is not limited thereto, and the material included in the supporter 190 may be changed in various ways. Additionally, in some implementations, the first supporter 191, the second supporter 192, and the third supporter 193 may include different materials.

According to some implementations, the auxiliary layer 300 may be positioned on the lower electrodes 170. The auxiliary layer 300 may serve to improve capacitance by preventing a depletion layer from occurring at an interface between the lower electrode 170 and the dielectric layer 180. For example, the auxiliary layer 300 may be deposited on the lower electrodes 170 and the supporter 190, and then may be formed by etching and removing a portion positioned on the supporter 190. Accordingly, the auxiliary layer 300 may be positioned on the lower electrode 170 and may not be positioned on the supporter 190.

The auxiliary layer 300 may be positioned to cover a portion of the upper and side surfaces of the lower electrode 170. The auxiliary layer 300 may be positioned on a side portion of the lower electrode 170 other than a side portion of the lower electrode 170 that is in contact with the supporter 190. A portion of the auxiliary layer 300 positioned on the side surface of the lower electrode 170 may be positioned on a portion of the supporter 190 extending from the side surface of the lower electrode 170 and a portion of the etch stop layer 162. However, in some cases, the auxiliary layer 300 may not be positioned on the supporter 190 and the etch stop layer 162 at all.

According to some implementations, the auxiliary layer 300 may include a first auxiliary layer 310 including a conductive first material and a second auxiliary layer 320 including an insulating second material.

The first material may include a first metal. The first material may include, e.g., at least one of the first metal, an oxide of the first metal, or a nitride of the first metal. The first metal may include, e.g., scandium (Sc), yttrium (Y), titanium (Ti), vanadium (V), niobium (Nb), tantalum (Ta), chromium (Cr), molybdenum (Mo), tungsten (W), iron (Fe), ruthenium (Ru), osmium (Os), cobalt (Co), rhodium (Rh), iridium (Ir), boron (B), or tin (Sn), but the present disclosure is not limited thereto.

According to some implementations, the first material may include a tantalum oxide (TaOx). If the tantalum oxide is used as an interface material between the lower electrode 170 and the dielectric layer 180, operating characteristics of the semiconductor device 100 may be improved.

The first auxiliary layer 310 may have a single layer structure or a multilayer structure including the first material. According to some implementations, the first auxiliary layer 310 may further include a third material. The third material may be a different material from the first material. The third material may include, e.g., at least one of the third metal, an oxide of the third metal, or a nitride of the third metal. The third metal may include, e.g., scandium (Sc), yttrium (Y), titanium (Ti), vanadium (V), niobium (Nb), tantalum (Ta), chromium (Cr), molybdenum (Mo), tungsten (W), iron (Fe), ruthenium (Ru), osmium (Os), cobalt (Co), rhodium (Rh), iridium (Ir), boron (B), or tin (Sn), but the present disclosure is not limited thereto.

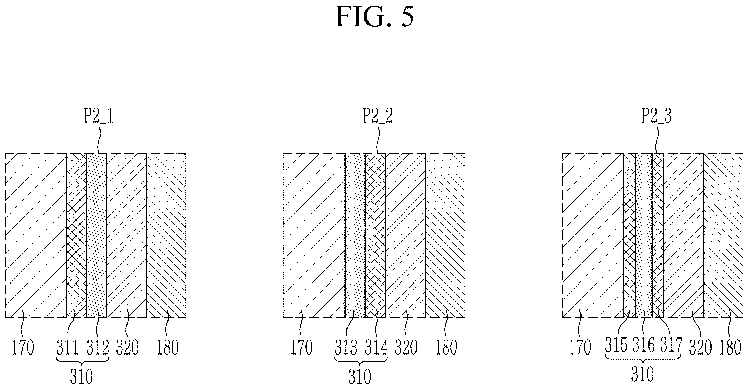

According to some implementations, the first auxiliary layer 310 may have a multilayer structure including the first material and the third material. According to some implementations, the first auxiliary layer 310 may have a structure in which at least one layer including the first material and at least one layer including the third material are stacked. For example, the first auxiliary layer 310 may have a double-layer structure in which the first material and third material are sequentially stacked, or a triple-layer structure in which the first material and third material are stacked alternately, but the present disclosure is not limited to this and includes more layers. Various implementations in which the first auxiliary layer 310 has a multilayer structure will be described in detail later with reference to FIG. 5.

The second material may include a second metal. The second material may include, e.g., an oxide of the second metal. The second metal may include, e.g., hafnium (Hf), zirconium (Zr), or aluminum (Al), but the present disclosure is not limited thereto. According to some implementations, the second material may include a hafnium oxide (HfOₓ), a zirconium oxide (ZrOₓ), or an aluminum oxide (AlOₓ).

The second auxiliary layer 320 may be a single layer or a mixed layer containing the second material. For example, the second auxiliary layer 320 may be a single layer containing any one of a hafnium oxide (HfOₓ), a zirconium oxide (ZrOₓ), or an aluminum oxide (AlOₓ).

According to some implementations, the second auxiliary layer 320 may be a mixed layer of a plurality of metal oxides. According to some implementations, the second auxiliary layer 320 may further include at least one material different from the second material. The second auxiliary layer 320 may be a mixed layer of the second material and at least one material different from the second material. For example, the second auxiliary layer 320 may be a mixed layer of at least two materials among a hafnium oxide (HfOₓ), a zirconium oxide (ZrOₓ), or an aluminum oxide (AlOₓ).

For example, the auxiliary layer 300 may be deposited on the lower electrodes 170 and the supporter 190, and then may be formed by etching and removing a portion positioned on the supporter 190. A heat treatment process may be performed between a deposition process and an etching process of the auxiliary layer 300.

The second material may diffuse into the supporter 190 by heat treatment. Compared to a speed at which the second material diffuses into the lower electrode 170, a speed at which the second material diffuses into the supporter 190 may be faster. After the heat treatment, the second material does not exist in a portion close to the surface within the lower electrode 170, and a portion close to the surface within the supporter 190 may be mixed with a material of the supporter 190.

After the heat treatment, the first material may be etched. According to some implementations, a rate at which the first material is etched on the supporter 190 may be faster than a rate at which the first material is etched on the lower electrode 170. For example, if the second material and the material of the supporter 190 are mixed, in a case of etching the first material, the second material and the material of the supporter 190 may be etched together. As a surface of the supporter 190, in which the second material and the material of the supporter 190 are mixed, is etched, the first material positioned on the surface of the supporter 190 to be etched may also be removed. In this case, even if the rate at which the first material is directly etched is slow, it may be removed together as the surface of the supporter 190 is etched, so an amount of the first material on the surface of the supporter 190 may be reduced compared to an amount of the first material on a surface of the lower electrode 170.

In the present disclosure, the amount of the first material on the surface of the lower electrode 170 may refer to a ratio of a number of particles of the first material remaining on the surface of the lower electrode 170 to a number of particles of the materials on the surface of the lower electrode 170. Materials on the surface of the lower electrode 170 may include the material of the lower electrode 170 and the first material.

In addition, the amount of the first material on the surface of the supporter 190 may refer to a ratio of a number of particles of the first material remaining on the surface of the supporter 190 to a number of particles of the materials on the surface of the supporter 190. Materials on the surface of the supporter 190 may include the material of the supporter 190 and the first material.

According to some implementations, if the first auxiliary layer 310 and the second auxiliary layer 320 are formed together between the lower electrode 170 and the dielectric layer 180, compared to a comparative example in which the first auxiliary layer 310 is formed between the lower electrode 170 and the dielectric layer 180 without the second auxiliary layer 320, the amount of the first material on the surface of the supporter 190 may be reduced compared to the amount of the first material on the surface of the lower electrode 170. According to some implementations, the amount of the first material on the surface of the supporter 190 may be 10 % or less of the amount of the first material on the surface of the lower electrode 170.

The first auxiliary layer 310 and the second auxiliary layer 320 may be disposed sequentially between the lower electrode 170 and the dielectric layer 180. According to the implementation shown in FIG. 3, the first auxiliary layer 310 may be disposed on the lower electrode 170, the second auxiliary layer 320 may be disposed on the first auxiliary layer 310, and the dielectric layer 180 may be disposed on the second auxiliary layer 320.

The first auxiliary layer 310 may be disposed to cover a portion of the upper and side surfaces of the lower electrode 170. The first auxiliary layer 310 may be positioned on a side portion of the lower electrode 170 other than a side portion of the lower electrode 170 that is in contact with the supporter 190. A portion of the first auxiliary layer 310 disposed on the side surface of the lower electrode 170 may contact a portion of the supporter 190 extending from the side surface of the lower electrode 170 and a portion of the etch stop layer 162.

The second auxiliary layer 320 may be disposed on the first auxiliary layer 310, to cover the upper surface and a portion of the side surface of the lower electrode 170. The second auxiliary layer 320 may be spaced apart from the lower electrode 170, the supporter 190, and the etch stop layer 162 with the first auxiliary layer 310 provided therebetween.

The dielectric layer 180 may be disposed on the lower electrode 170 and the supporter 190. According to some implementations, the dielectric layer 180 may be disposed on the auxiliary layer 300 disposed on the lower electrode 170. According to some implementations, the dielectric layer 180 may be disposed directly on the supporter 190.

The dielectric layer 180 may be disposed on a portion of a side surface and an upper surface of the lower electrode 170 with the auxiliary layer 300 provided therebetween. The dielectric layer 180 may be disposed on a side portion of the lower electrode 170 other than a side portion of the lower electrode 170 that is in contact with the supporter 190.

The dielectric layer 180 may be disposed on the auxiliary layer 300 covering a portion of the side surface and the upper surface of the lower electrode 170. According to the implementation illustrated in FIG. 3, the dielectric layer 180 may be positioned directly on the second auxiliary layer 320. The dielectric layer 180 may be disposed on the second auxiliary layer 320 with the first auxiliary layer 310 provided therebetween. According to some implementations, the lower electrode 170, the first auxiliary layer 310, the second auxiliary layer 320, and the dielectric layer 180 may be positioned in that order.

The dielectric layer 180 may extend from on the auxiliary layer 300 covering the side surface of the lower electrode 170 onto the upper and lower surfaces of the supporter 190. According to the implementation illustrated in FIG. 3, a portion of the dielectric layer 180 extending from the second auxiliary layer 320 covering the side surface of the lower electrode 170 onto the upper and lower surfaces of the supporter 190 may be in contact with a portion of the first auxiliary layer 310 extending from the side of the lower electrode 170 onto the upper and lower surfaces of the supporter 190. The dielectric layer 180 may extend over the upper and lower surfaces of the supporter 190 from the second auxiliary layer 320 covering the side surface of the lower electrode 170 and the first auxiliary layer 310 extending from the side surface of the lower electrode 170 to the upper and lower surfaces of the supporter 190.

The dielectric layer 180 may be positioned on the etch stop layer 162.

For example, the dielectric layer 180 may include at least one of a zirconium oxide, a hafnium oxide, a titanium oxide, a niobium oxide, a tantalum oxide, a yttrium oxide, a strontium titanium oxide, a barium strontium titanium oxide, a scandium oxide, or a lanthanide oxide. Additionally, the dielectric layer 180 may include hafnium oxide predominantly having a tetragonal crystal phase.

In some implementations, the dielectric layer 180 may have a multi-layer structure formed by a stacked structure of a first dielectric layer and a second dielectric layer, and at least one of the first dielectric layer or the second dielectric layer may include a hafnium oxide formed to predominantly have a tetragonal crystal phase. However, a material included in the dielectric layer 180 is not limited thereto and may be variously changed.

According to some implementations, the dielectric layer 180 may be formed in a separate process from that of the auxiliary layer 300. For example, the auxiliary layer 300 may be deposited on the lower electrodes 170 and the supporter 190, and after the auxiliary layer 300 positioned on the supporter 190 is removed, the dielectric layer 180 may be deposited on the lower electrodes 170 and the supporter 190. Accordingly, the auxiliary layer 300 may be disposed between the lower electrodes 170 and the dielectric layer 180, and the auxiliary layer 300 may not be positioned between the supporter 190 and the dielectric layer 180.

The upper electrode 200 may be positioned on the dielectric layer 180.

For example, the upper electrode 200 may include at least one selected from among a metal such as ruthenium (Ru), titanium (Ti), tantalum (Ta), niobium (Nb), iridium (Ir), molybdenum (Mo), or tungsten (W), a conductive metal nitride such as a titanium nitride (TiN), a tantalum nitride (TaN), a niobium nitride (NbN), a molybdenum nitride (MoN), or a tungsten nitride (WN), and a conductive metal oxide such as an iridium oxide (IrO₂), a ruthenium oxide (RuO₂), or a strontium ruthenium oxide (SrRuO₃). However, a material included in the upper electrode 200 is not limited thereto and may be variously changed.

In some implementations, the upper electrode 200 may be made of a single material layer or a stacked structure of multiple material layers. For example, the upper electrode 200 may be made of a single layer of a titanium nitride (TiN) or a single layer of a niobium nitride (NbN).

According to the capacitor structure CS and the semiconductor device 100 including the same according to some implementations, a ratio of an amount of the conductive first material positioned between the supporter 190 and the dielectric layer 180 compared to an amount positioned between the lower electrode 170 and the dielectric layer 180 may be reduced. Adjacent lower electrodes 170 may be short-circuited by the conductive first material positioned on the supporter 190, which may be referred to as a bridge defect. In some implementations, leakage current between adjacent lower electrodes 170 and resulting bridge defects may be reduced by leaving almost no first material on the supporter 190.

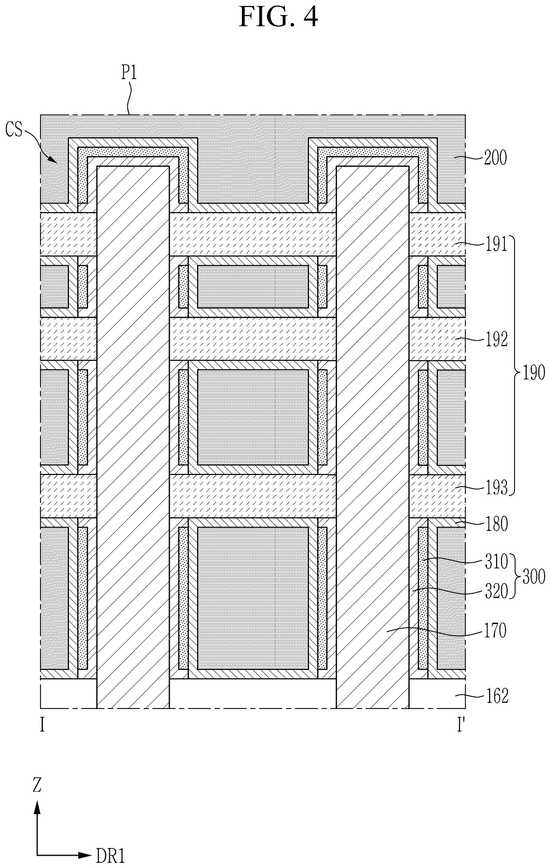

FIG. 4 illustrates an enlarged view of the region P1 of FIG. 2 to show a capacitor structure according to some implementations. Hereinafter, the implementation shown in FIG. 4 will be described focusing on differences from the implementation shown in FIG. 3, and redundant descriptions of each configuration may be briefly described or omitted.

Referring to FIG. 4, the first auxiliary layer 310 and the second auxiliary layer 320 may be sequentially positioned between the lower electrode 170 and the dielectric layer 180, and the dielectric layer 180 may be disposed directly on the supporter 190. According to the implementation shown in FIG. 4, the second auxiliary layer 320 may be disposed on the lower electrode 170, the first auxiliary layer 310 may be disposed on the second auxiliary layer 320, and the dielectric layer 180 may be disposed on the first auxiliary layer 310.

Specifically, the second auxiliary layer 320 may be positioned to cover a portion of the upper and side surfaces of the lower electrode 170. The second auxiliary layer 320 may be positioned on a side portion of the lower electrode 170 other than a side portion of the lower electrode 170 that is in contact with the supporter 190. A portion of the second auxiliary layer 320 disposed on the side surface of the lower electrode 170 may contact a portion of the supporter 190 extending from the side surface of the lower electrode 170 and a portion of the etch stop layer 162.

The first auxiliary layer 310 may be disposed on the second auxiliary layer 320, to cover the upper surface and a portion of the side surface of the lower electrode 170. The first auxiliary layer 310 may be spaced apart from the lower electrode 170, the supporter 190, and the etch stop layer 162 with the second auxiliary layer 320 provided therebetween.

According to the implementation illustrated in FIG. 4, the dielectric layer 180 may be positioned directly on the first auxiliary layer 310. The dielectric layer 180 may be disposed on the first auxiliary layer 310 with the second auxiliary layer 320 provided therebetween. According to some implementations, the lower electrode 170, the second auxiliary layer 320, the first auxiliary layer 310, and the dielectric layer 180 may be positioned in that order.

According to the implementation illustrated in FIG. 4, a portion of the dielectric layer 180 extending from on the first auxiliary layer 310 covering the side surface of the lower electrode 170 onto the upper and lower surfaces of the supporter 190 may be in contact with a portion of the second auxiliary layer 320 extending from the side of the lower electrode 170 onto the upper and lower surfaces of the supporter 190. The dielectric layer 180 may extend over the upper and lower surfaces of the supporter 190 from the first auxiliary layer 310 covering the side surface of the lower electrode 170 and the second auxiliary layer 320 extending from the side surface of the lower electrode 170 to the upper and lower surfaces of the supporter 190.

According to some implementations, if the first auxiliary layer 310 is etched on the supporter 190, the second auxiliary layer 320 may also be etched. For example, in a heat treatment process before etching, the second material of the second auxiliary layer 320 may diffuse to a surface of the supporter 190 to be mixed with a material of the supporter 190. The surface of the supporter 190, where the second material and the material of the supporter 190 are mixed, may be etched together when the first material is etched. Accordingly, the dielectric layer 180 may be positioned directly on the supporter 190.

As the surface of the supporter is etched, the first material positioned on the surface of the supporter 190 to be etched may also be removed. Even if the second auxiliary layer 320 and the first auxiliary layer 310 are deposited in that order on the lower electrode 170 and the supporter 190, a rate at which the first material is etched on the surface of the supporter 190 may be faster than a rate at which the first material is etched on the surface of the lower electrode 170. After etching, an amount of the first material remaining on the surface of the supporter 190 may be smaller than an amount of the first material remaining on the surface of the lower electrode 170.

According to some implementations, the amount of the first material on the surface of the supporter 190 may be 10 % or less of the amount of the first material on the surface of the lower electrode 170. The amount of the first material on the surface of the supporter 190 may refer to a ratio of a number of particles of the first material remaining on the surface of the supporter 190 to a number of particles of the materials on the surface of the supporter 190. Materials on the surface of the supporter 190 may include the material of the supporter 190 and the first material. The amount of the first material on the surface of the lower electrode 170 may refer to a ratio of a number of particles of the first material remaining on the surface of the lower electrode 170 to a number of particles of the materials on the surface of the lower electrode 170. Materials on the surface of the lower electrode 170 may include the material of the lower electrode 170 and the first material.

Even if the second auxiliary layer 320 and the first auxiliary layer 310 are deposited in that order on the lower electrode 170 and the supporter 190, a ratio of the amount of the first material on the surface of the supporter 190 to the amount of the first material on the surface of the lower electrode 170 after etching may be reduced compared to a case where the first auxiliary layer 310 is formed without forming the second auxiliary layer 320.

As the amount of the first conductive material remaining on the surface of the supporter 190 decreases, a current leaking between neighboring lower electrodes 170 through the supporter 190 may decrease, and bridge defects may be reduced.

FIG. 5 illustrates enlarged views of a region P2 of FIG. 3 to show the first auxiliary layer 310 according to various implementations.

According to various implementations, the first auxiliary layer 310 may have a multilayer structure. The first auxiliary layer 310 may have a multilayer structure including a first material and a third material different from the first material. The first auxiliary layer 310 may have a structure in which at least one layer including the first material and at least one layer including the third material are stacked.

The first material may include a first metal, an oxide of the first metal, or a nitride of the first metal. The third material may include a third metal, an oxide of a third metal, or a nitride of a third metal. The first metal or the third metal may include, e.g., scandium (Sc), yttrium (Y), titanium (Ti), vanadium (V), niobium (Nb), tantalum (Ta), chromium (Cr), molybdenum (Mo), tungsten (W), iron (Fe), ruthenium (Ru), osmium (Os), cobalt (Co), rhodium (Rh), iridium (Ir), boron (B), or tin (Sn), but the present disclosure is not limited thereto, and may be changed in various ways. The first metal and the third metal may be the same metal or different metals.

For example, the first material may be a titanium oxide and the third material may be a tantalum oxide, but the present disclosure is not limited thereto, and the first and third materials may be changed in various ways.

Referring to a first enlarged view P2_1, the first auxiliary layer 310 may include a first layer 311 including a first material and a second layer 312 including a third material. According to some implementations, the first layer 311 including the first material and the second layer 312 including the third material may be sequentially stacked on the lower electrode 170. For example, the first layer 311 may be disposed on the lower electrode 170, and the second layer 312 may be disposed on the first layer 311. That is, the first layer 311 may be disposed between the lower electrode 170 and the second layer 312. The second auxiliary layer 320 may be disposed on the second layer 312. The dielectric layer 180 may be disposed on the second auxiliary layer 320.

Although not illustrated, the second auxiliary layer 320 may be disposed on the lower electrode 170, and the first layer 311 and the second layer 312 may be sequentially stacked on the second auxiliary layer 320. For example, the first layer 311 may be disposed on the second auxiliary layer 320, and the second layer 312 may be disposed on the first layer 311. That is, the second auxiliary layer 320 may be disposed between the lower electrode 170 and the first layer 311, and the first layer 311 may be disposed between the second auxiliary layer 320 and the second layer 312. The dielectric layer 180 may be disposed on the second layer 312.

Referring to a second enlarged view P2_2, the first auxiliary layer 310 may include a third layer 313 including a third material and a fourth layer 314 including the first material. According to some implementations, the third layer 313 including the third material and the fourth layer 314 including the first material may be sequentially stacked on the lower electrode 170. For example, the third layer 313 may be disposed on the lower electrode 170, and the fourth layer 314 may be disposed on the third layer 313. The second auxiliary layer 320 may be disposed on the fourth layer 314. The dielectric layer 180 may be disposed on the second auxiliary layer 320.

Although not illustrated, the second auxiliary layer 320 may be disposed on the lower electrode 170, and the third layer 313 and the fourth layer 314 may be sequentially stacked on the second auxiliary layer 320. For example, the third layer 313 may be disposed on the second auxiliary layer 320, and the fourth layer 314 may be disposed on the third layer 313. The dielectric layer 180 may be disposed on the fourth layer 314.

Referring to a third enlarged view P2_3, the first auxiliary layer 310 may include a fifth layer 315 and a seventh layer 317 including the first material, and a sixth layer 316 including the third material. According to some implementations, a layer including the first material and a layer including the third material may be alternately stacked between the lower electrode 170 and the dielectric layer 180. According to some implementations, the fifth layer 315 including the first material, the sixth layer 316 including the third material, and the seventh layer 317 including the first material may be stacked on the lower electrode 170 in that order. For example, the fifth layer 315 may be disposed on the lower electrode 170, the sixth layer 316 may be disposed on the fifth layer 315, and the seventh layer 317 may be disposed on the sixth layer 316. That is, the sixth layer 316 may be disposed between the fifth layer 315 and the seventh layer 317. The second auxiliary layer 320 may be disposed on the seventh layer 317. The dielectric layer 180 may be disposed on the second auxiliary layer 320.

Although not illustrated, the second auxiliary layer 320 is disposed on the lower electrode 170, and the fifth layer 315, the sixth layer 316, and the seventh layer 317 may be sequentially stacked on the second auxiliary layer 320. For example, the fifth layer 315 may be disposed on the second auxiliary layer 320, the sixth layer 316 may be disposed on the fifth layer 315, and the seventh layer 317 may be disposed on the sixth layer 316. The dielectric layer 180 may be disposed on the seventh layer 317.

A structure of the first auxiliary layer 310 and a number of materials constituting the first auxiliary layer 310 are not limited to the implementations described herein and may be changed in various ways. The first auxiliary layer 310 may include a single layer or four or more layers or may include three or more materials.

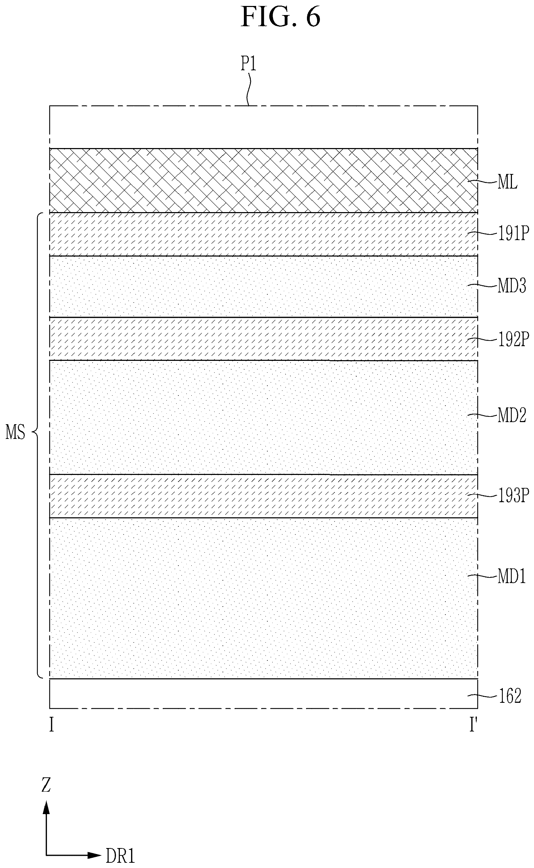

Hereinafter, a method of manufacturing the capacitor structure CS of FIG. 3 will be described with reference to FIG. 6 to FIG. 16. Hereinafter, same reference numerals refer to components identical to those previously described, and redundant descriptions will be omitted or simplified, and description will focus on differences.

FIG. 6 to FIG. 16 illustrate cross-sectional views showing a manufacturing method for the capacitor structure CS according to some implementations. FIG. 6 to FIG. 16 correspond to a region P1 positioned on the etch stop layer 162 of FIG. 2, and as illustrated in FIG. 2, the etch stop layer 162 may be disposed on the substrate 110.

Referring to FIG. 6, a mold structure MS may be positioned on the etch stop layer 162. The mold structure MS may include mold layers MD1, MD2, and MD3 and preliminary supporter layers 191P, 192P, and 193P that are alternately stacked on the etch stop layer 162. The mold layers MD1, MD2, and MD3 may include materials that have etch selectivity with respect to the etch stop layer 162. For example, if the mold layers MD1, MD2, and MD3 include a silicon oxide, the etch stop layer 162 may include a silicon nitride, a silicon boronitride, a silicon oxynitride, a silicon carbonate, a silicon carbonate nitride, or a silicon carbide nitride (SiCN) or combinations thereof.

Additionally, the mold layers MD1, MD2, and MD3 may include materials that have etch selectivity with respect to the preliminary supporter layers 191P, 192P, and 193P. For example, if mold layers MD1, MD2, and MD3 include a silicon oxide, the preliminary supporter layers 191P, 192P, and 193P may include a silicon nitride, a silicon oxynitride, a silicon boron nitride (SiBN), or a silicon carbide nitride (SiCN).

Materials of the mold layers MD1, MD2, and MD3, the preliminary supporter layers 191P, 192P, and 193P, and the etch stop layer 162 are not limited thereto and may vary in various ways.

Next, a mask layer ML may be formed on the mold structure MS. The mask layer ML may include a material having etch selectivity with respect to the first preliminary supporter layer 191P and a lower electrode layer 170P, which will be described later.

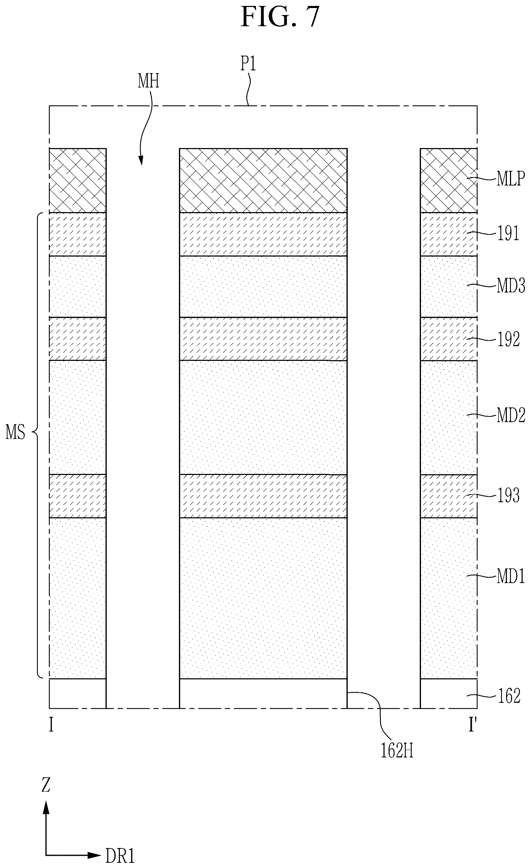

Referring to FIG. 7 , the mask layer ML may be patterned to form a mask pattern MLP. The mask pattern MLP may be formed by removing at least a portion of the mask layer ML. As the mask pattern MLP is formed, at least a portion of the mold structure MS may be exposed to an outside. For example, the first preliminary supporter layer 191P positioned at an uppermost portion may be exposed to the outside. The mold structure MS and the etch stop layer 162 may be etched using the mask pattern MLP. Accordingly, an opening MH extending through the mask layer ML and the mold structure MS, and an etch stop layer opening 162H extending through the etch stop layer 162 may be formed.

As the preliminary supporter layers 191P, 192P, and 193P are etched, as illustrated in FIG. 7, a first supporter 191, a second supporter 192, and a third supporter 193 may be formed, which are sequentially positioned from an upper portion to a lower portion of the mold structure MS.

The opening MH and the etch stop layer opening 162H may correspond to a portion from which the mold structure MS and the mask layer ML were removed and a portion from which a portion of the etch stop layer 162 was removed, respectively. Although not illustrated in this drawing, an upper surface of the landing pad 152 of FIG. 2 may be exposed as the opening MH and the etch stop layer opening 162H are formed.

In FIG. 7, a width of the opening MH is shown to be the same from an upper region to a lower region, but as the opening MH has an aspect ratio, it may have a shape where the width decreases from the upper region to the lower region of the opening MH. In this case, a side surface of the opening MH may have an inclined surface. However, a shape of the opening MH is not limited thereto and may change in various ways according to a forming process of the opening MH.

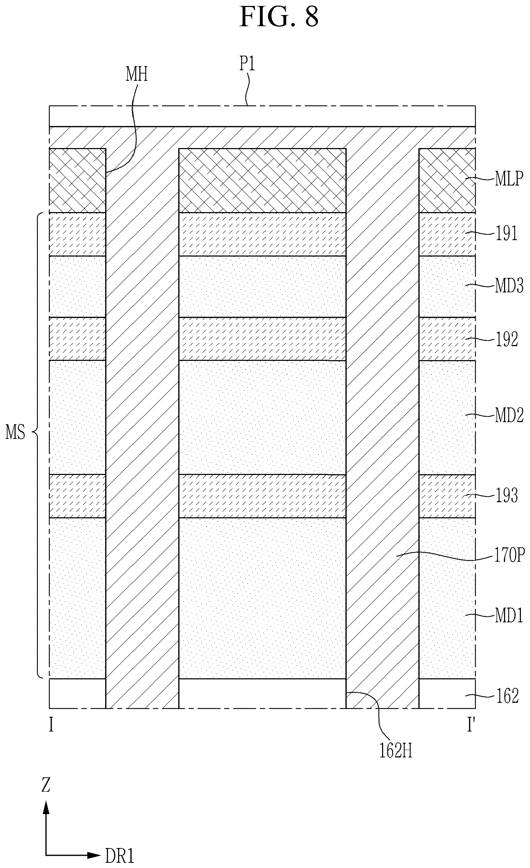

Referring to FIG. 8, the lower electrode layer 170P may be disposed on an upper surface of the mask pattern MLP and within the opening MH. The lower electrode layer 170P may fill insides of the opening MH and the etch stop layer opening 162H. Additionally, the lower electrode layer 170P may be formed to cover the upper surface of the mask pattern MLP.

The lower electrode layer 170 may include at least one of a metal such as ruthenium (Ru), titanium (Ti), tantalum (Ta), niobium (Nb), iridium (Ir), molybdenum (Mo), or tungsten (W), or a conductive metal nitride such as a titanium nitride (TiN), a tantalum nitride (TaN), a niobium nitride (NbN), a molybdenum nitride (MoN), or a tungsten nitride (WN). However, a material included in the lower electrode layer 170P is not limited thereto and may be variously changed.

For example, the lower electrode layer 170P may be formed using a chemical vapor deposition (CVD) process, a metal organic chemical vapor deposition (MOCVD) process, an atomic layer deposition (ALD) process, a metal organic vapor deposition (CVD) process, a metal organic atomic layer deposition (MOALD) process, but the present disclosure is not limited thereto.

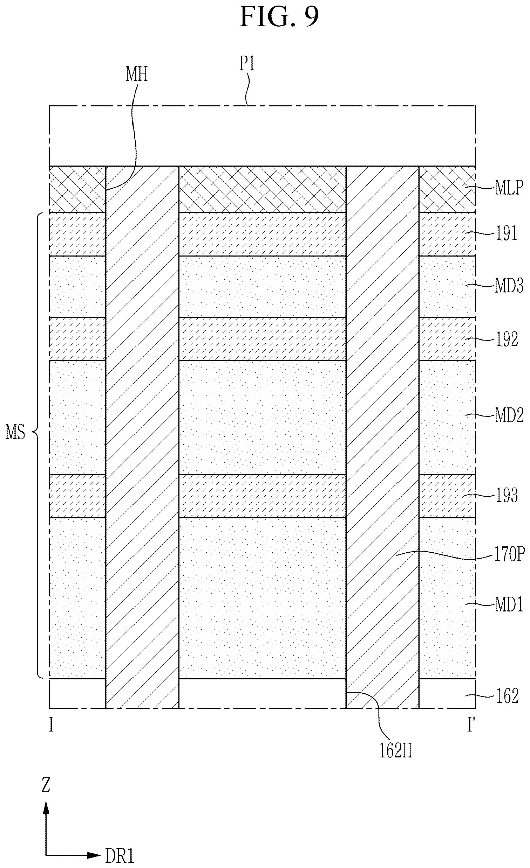

Referring to FIG. 9, a portion of the mask pattern MLP and a portion of the lower electrode layer 170P may be removed. As a portion of the mask pattern MLP and a portion of the lower electrode layer 170P are removed, a thickness of the mask pattern MLP in the third direction (direction Z) may decrease, and a portion of the lower electrode layer 170P surrounded by the mask pattern MLP may be removed together. The upper surface of the mask pattern MLP and the upper surface of the lower electrode layer 170P may be positioned at substantially a same level.

For example, a portion of the mask pattern MLP and a portion of the lower electrode layer 170P may be removed through a planarization process such as an etch back process or a chemical mechanical polishing (CMP) process, but the present disclosure is not limited thereto.

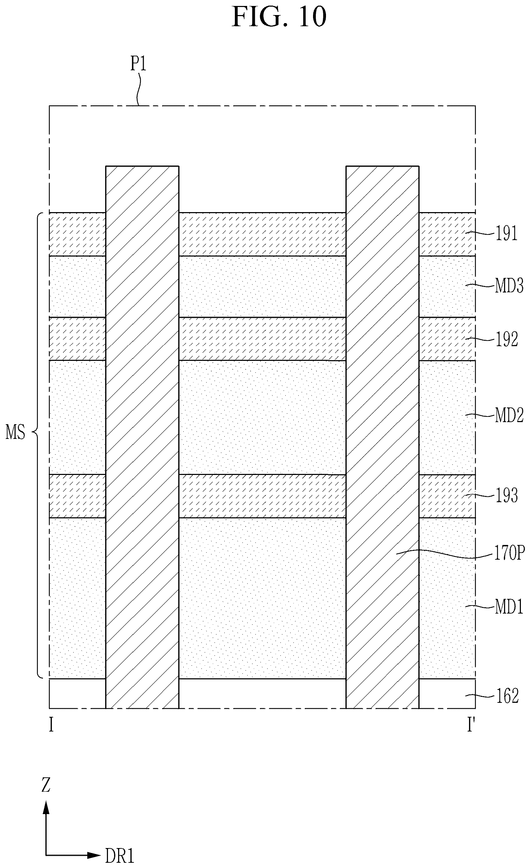

Referring to FIG. 10, the mask pattern MLP may be removed. As described above, since the mask pattern MLP has etch selectivity with respect to the lower electrode layer 170P, the mask pattern MLP surrounding the lower electrode layer 170P may be selectively removed. For example, the mask pattern MLP may be removed using an etchant having high etch selectivity with respect to the mask pattern MLP, but the present disclosure is not limited thereto.

As the mask pattern MLP is removed, the upper surface of the first supporter 191 and the side surface of the lower electrode layer 170P surrounded by the mask pattern MLP and may be exposed. A portion of the lower electrode layer 170P may protrude above the upper surface of the first supporter 191.

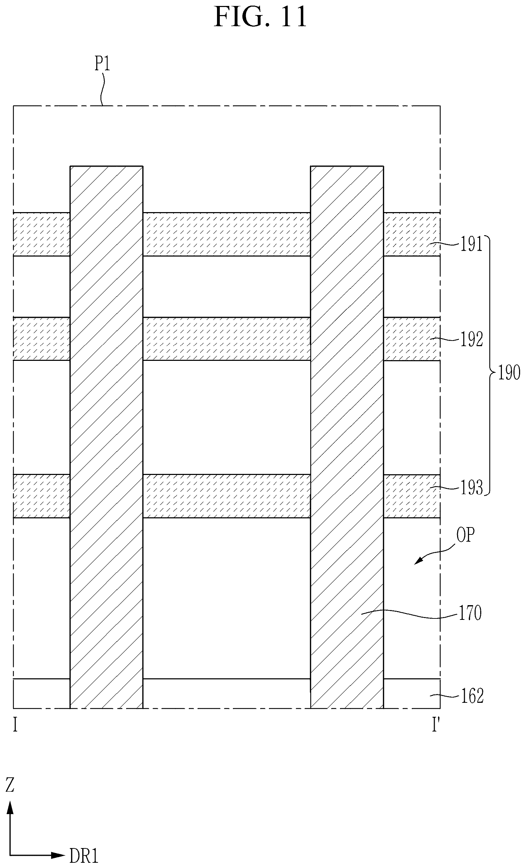

Referring to FIG. 11, the mold layers MD1, MD2, and MD3 are removed, and an empty space OP may be formed between the supporters 190 and between the supporter 190 and the etch stop layer 162. That is, as the mold layers MD1, MD2, and MD3 are removed, the upper and lower surfaces of the supporter 190, the upper surface of the etch stop layer 162, and the side of the lower electrode 170 may be exposed to empty spaces OP.

As described above, the mold layers MD1, MD2, and MD3 have etch selectivity with respect to the supporter 190 and the etch stop layer 162, and thus in a process of removing the mold layers MD1, MD2, and MD3, the supporter 190 and the etch stop layer 162 may not be removed. The supporter 190 may connect adjacent lower electrodes 170 to each other, and the lower electrodes 170 may be supported by the supporter 190.

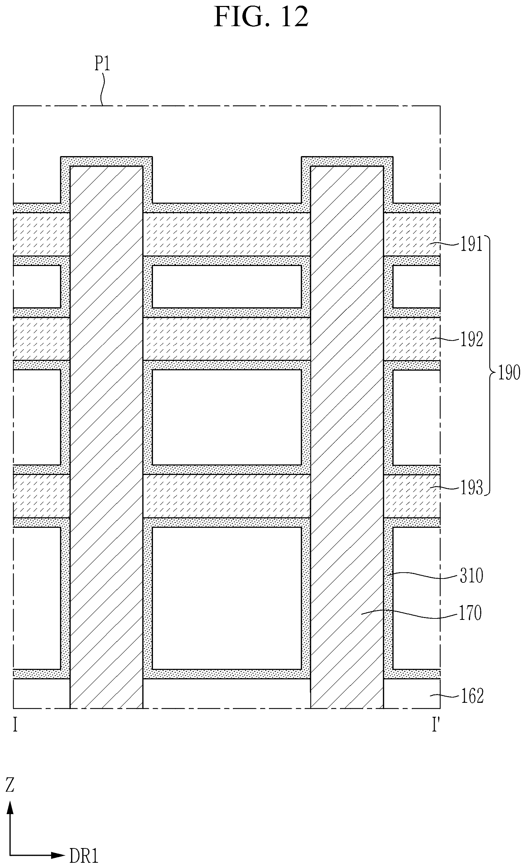

Referring to FIG. 12, a first auxiliary layer 310 may be formed. The first auxiliary layer 310 may be disposed on the lower electrodes 170, the supporter 190, and the etch stop layer 162. The first auxiliary layer 310 may be formed to cover a portion of the side surface and the upper surface of the lower electrodes 170. The first auxiliary layer 310 may cover a remaining portion of the side surface of the lower electrode 170 except for a portion in contact with the supporter 190. The first auxiliary layer 310 may be formed to cover the upper and lower surfaces of the supporter 190. The first auxiliary layer 310 may be formed to cover the upper surface of the etch stop layer 162.

The first auxiliary layer 310 may include a first conductive material. The first material may include at least one of the first metal, an oxide of the first metal, or a nitride of the first metal. The first metal may include, e.g., scandium (Sc), yttrium (Y), titanium (Ti), vanadium (V), niobium (Nb), tantalum (Ta), chromium (Cr), molybdenum (Mo), tungsten (W), iron (Fe), ruthenium (Ru), osmium (Os), cobalt (Co), rhodium (Rh), iridium (Ir), boron (B), or tin (Sn), but the present disclosure is not limited thereto.

According to some implementations, the first auxiliary layer 310 may include a tantalum oxide (TaOₓ). For example, the first auxiliary layer 310 may be formed as a single layer structure containing the tantalum oxide (TaOₓ).

As another example, the first auxiliary layer 310 may be formed as a multilayer. For example, when the first auxiliary layer 310 is formed as a multilayer, the first auxiliary layer 310 may be formed by alternately stacking at least one layer including the first material and at least one layer including the third material different from the first material.

The third material may include at least one of the third metal, an oxide of the third metal, or a nitride of the third metal. The third metal may include, e.g., scandium (Sc), yttrium (Y), titanium (Ti), vanadium (V), niobium (Nb), tantalum (Ta), chromium (Cr), molybdenum (Mo), tungsten (W), iron (Fe), ruthenium (Ru), osmium (Os), cobalt (Co), rhodium (Rh), iridium (Ir), boron (B), or tin (Sn), but the present disclosure is not limited thereto.

According to some implementations, the first material may be a tantalum oxide (TaOₓ), and the third material may be a titanium oxide (TiOₓ). According to some implementations, the first auxiliary layer 310 may have a multilayer structure in which layers including the tantalum oxide and layers including the titanium oxide are alternately stacked.

For example, the first auxiliary layer 310 may be formed by a chemical vapor deposition (CVD) process, a metal organic CVD (MOCVD) process, an atomic layer deposition (ALD) process, or a metal organic ALD (MOALD) process, but the present disclosure is limited thereto.

The first material may have poor adhesiveness with the material of the supporter 190 compared to adhesiveness with a material of the lower electrode 170. Accordingly, the first auxiliary layer 310 may be disposed sparsely on the surface of the supporter 190 and densely on the surface of the lower electrode 170. In FIG. 12, the first auxiliary layer 310 is illustrated to have same thickness and density on the lower electrode 170 and on the supporter 190, but the first auxiliary layer 310 disposed on the supporter 190 may be formed with a thinner thickness or a lower density than the first auxiliary layer 310 disposed on the lower electrode 170.

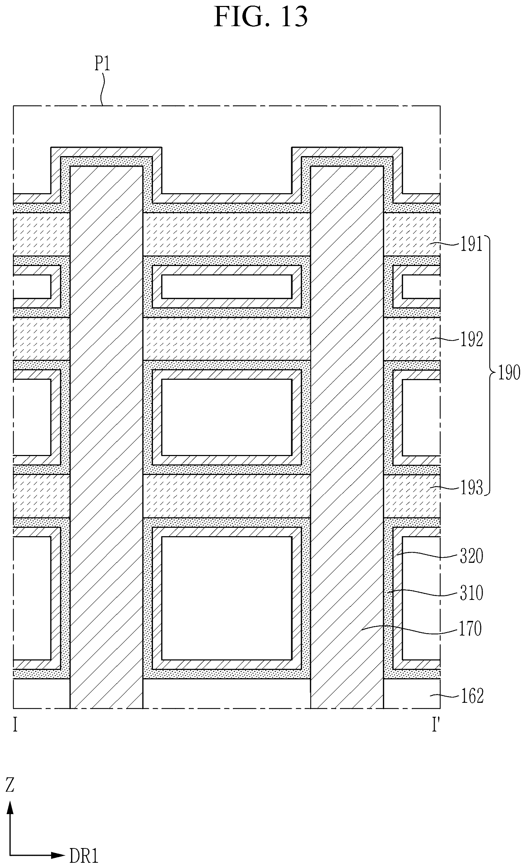

Referring to FIG. 13, the second auxiliary 320 may be disposed on the first auxiliary layer 310. The second auxiliary layer 320 may be disposed on the lower electrodes 170, the supporter 190, and the etch stop layer 162 with the first auxiliary layer 310 provided therebetween.

The second auxiliary layer 320 may be a single layer or a mixed layer containing the second material. The second material may include an oxide of the second metal. According to some implementations, the second auxiliary layer 320 may include at least one of a hafnium oxide (HfOₓ), a zirconium oxide (ZrOₓ), or an aluminum oxide (AlOₓ).

According to some implementations, the second auxiliary layer 320 may be formed as a single layer including a hafnium oxide, a zirconium oxide, or an aluminum oxide, but the present disclosure is not limited thereto. For example, the second auxiliary layer 320 may be formed as a mixed layer of two or more materials among a hafnium oxide, a zirconium oxide, or an aluminum oxide. As another example, the second auxiliary layer 320 may include a material other than the hafnium oxide, the zirconium oxide, or the aluminum oxide.

As described above, the first auxiliary layer 310 is disposed sparsely on the surface of the supporter 190, and thus a portion of the second auxiliary layer 320 may contact the surface of the supporter 190. That is, the second material of the second auxiliary layer 320 may be disposed between first materials of the first auxiliary layer 310 on the surface of the supporter 190.

Subsequently, if heat treatment is performed, the second material may diffuse toward the surface of the supporter 190. The second material may penetrate into the interior of the supporter 190, and the second material and the material of the supporter 190 may be mixed on the surface of the supporter 190.

Meanwhile, the second material may not mix well with the material of the lower electrode 170 compared to the material of the supporter 190. For example, a rate at which the second material diffuses into the lower electrode 170 may be significantly slower than a rate at which the second material diffuses into the supporter 190. In addition, the first auxiliary layer 310 is densely formed on the lower electrode 170, and thus it may be difficult for the second material of the second auxiliary layer 320 disposed on the first auxiliary layer 310 to diffuse through the first auxiliary layer 310. Accordingly, the second material may not penetrate into the lower electrode 170. The second material may not exist on the surface of the lower electrode 170, or even if it exists, it may be in a trace amount.

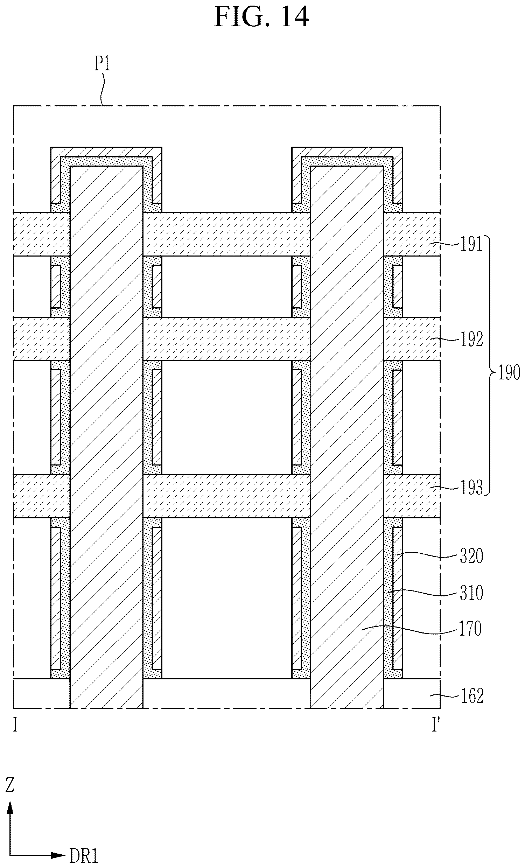

Referring to FIG. 14, a portion of the first auxiliary layer 310 and a portion of the second auxiliary layer 320 located on the supporter 190 may be selectively removed. A portion of the first auxiliary layer 310 and a portion of the second auxiliary layer 320 disposed on the etch stop layer 162 may also be removed. According to some implementations, a portion of the first auxiliary layer 310 and a portion of the second auxiliary layer 320 disposed on the supporter 190 may be removed through a process of etching the first material.

According to some implementations, the material of the supporter 190 and the second material disposed on the surface of the supporter 190 may be etched together in the etching process of the first material. For example, if the second material and the material of the supporter 190 are mixed, in the process of etching the first material, the second material and the material of the supporter 190 may be etched together. As a surface of the supporter 190, in which the second material and the material of the supporter 190 are mixed, is etched, the first material positioned on the surface of the supporter 190 to be etched may also be removed. Accordingly, even if the rate at which the first material is directly etched is slow, the first material may be removed together as the surface of the supporter 190 is etched, thereby increasing the rate at which the first material is etched on the surface of the supporter 190. According to some implementations, the rate at which the first material is etched on the surface of the supporter 190 may be faster than the rate at which the first material is etched on the surface of the lower electrode 170.

As described above, the second material may not be mixed with the material of the lower electrode 170, and during the etching process of the first material, the lower electrode 170 and the second auxiliary layer 320 disposed on the lower electrode 170 may be maintained. Accordingly, the first material positioned on the lower electrode 170 may be removed by direct etching, and the first auxiliary layer 310 disposed on the lower electrode 170 may be maintained.

According to some implementations, the amount of the first material on the surface of the supporter 190 may be 10 % or less of the amount of the first material on the surface of the lower electrode 170. The amount of the first material on the surface of the supporter 190 may refer to a ratio of a number of particles of the first material remaining on the surface of the supporter 190 to a number of particles of the materials on the surface of the supporter 190. Materials on the surface of the supporter 190 may include the material of the supporter 190 and the first material. The amount of the first material on the surface of the lower electrode 170 may refer to a ratio of a number of particles of the first material remaining on the surface of the lower electrode 170 to a number of particles of the materials on the surface of the lower electrode 170. Materials on the surface of the lower electrode 170 may include the material of the lower electrode 170 and the first material.

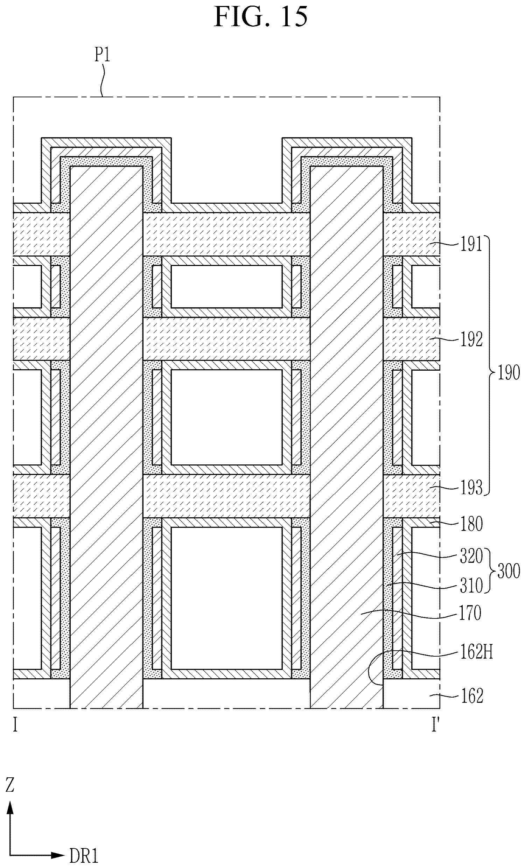

Referring to FIG. 15, the dielectric layer 180 may be conformally disposed on the lower electrodes 170, the supporter 190, and the etch stop layer 162. The dielectric layer 180 may be formed to cover a portion of the side surface and the upper surface of the lower electrode 170 with the first auxiliary layer 310 and the second auxiliary layer 320 provided therebetween. The dielectric layer 180 may cover a remaining portion of the side surface of the lower electrode 170 except for a portion in contact with the supporter 190. The dielectric layer 180 may be formed to cover the upper and lower surfaces of the supporter 190. The dielectric layer 180 may be formed to cover the etch stop layer 162.

For example, the dielectric layer 180 may include at least one of a zirconium oxide, a hafnium oxide, a titanium oxide, a niobium oxide, a tantalum oxide, a yttrium oxide, a strontium titanium oxide, a barium strontium titanium oxide, a scandium oxide, or a lanthanide oxide. Additionally, the dielectric layer 180 may include hafnium oxide predominantly having a tetragonal crystal phase.

For example, the dielectric layer 180 may be formed by a chemical vapor deposition (CVD) process, a metal organic CVD (MOCVD) process, an atomic layer deposition (ALD) process, or a metal organic ALD (MOALD) process, but the present disclosure is limited thereto.

According to some implementations, the first auxiliary layer 310 and the second auxiliary layer 320 may be disposed sequentially between the lower electrode 170 and the dielectric layer 180. That is, the lower electrode 170, the first auxiliary layer 310, the second auxiliary layer 320, and the dielectric layer 180 may be disposed in that order, but the present disclosure is not limited thereto. As in the embodiment shown in FIG. 4, the lower electrode 170, the second auxiliary layer 320, the first auxiliary layer 310, and the dielectric layer 180 may be arranged in that order.

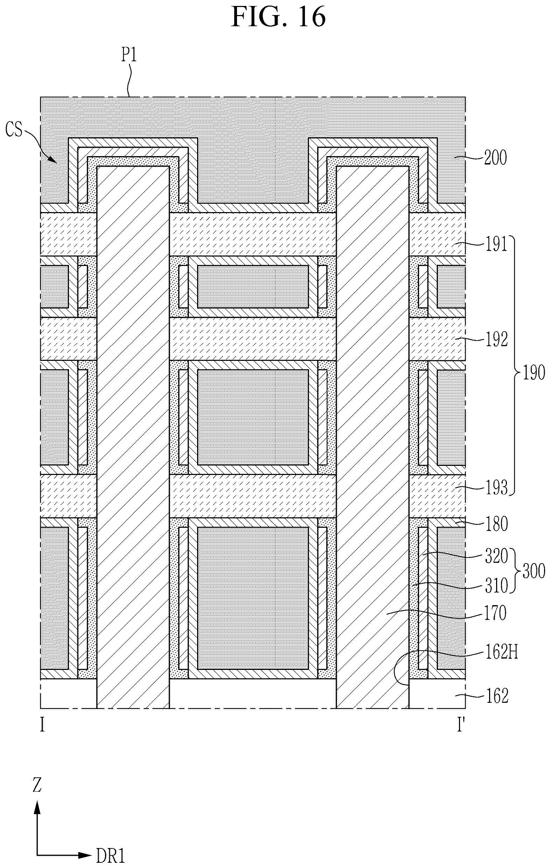

Referring to FIG. 16, the upper electrode 200 may be disposed on the dielectric layer 180 and the supporter 190. The upper electrode 200 may be formed to cover a portion of the side surface and the upper surface of the lower electrode 170 with the dielectric layer 180 provided therebetween. The upper electrode 200 may cover a remaining portion of the side surface of the lower electrode 170 except for a portion in contact with the supporter 190. The upper electrode 200 may be formed to cover the supporter 190 and the etch stop layer 162 with the dielectric layer 180 provided therebetween.

For example, the upper electrode 200 may include at least one selected from among a metal such as ruthenium (Ru), titanium (Ti), tantalum (Ta), niobium (Nb), iridium (Ir), molybdenum (Mo), or tungsten (W), a conductive metal nitride such as a titanium nitride (TiN), a tantalum nitride (TaN), a niobium nitride (NbN), a molybdenum nitride (MoN), or a tungsten nitride (WN), and a conductive metal oxide such as an iridium oxide (IrO₂), a ruthenium oxide (RuO₂), or a strontium ruthenium oxide (SrRuO₃). However, a material included in the upper electrode 200 is not limited thereto and may be variously changed.

The capacitor structure CS shown in FIG. 3 may be manufactured through the processes of FIGS. 6 to 16. According to the method of manufacturing the capacitor structure CS according to the implementations shown in FIGS. 6 to 16, the first auxiliary layer 310 including a conductive first material and the second auxiliary layer 320 including an insulating second material may be positioned between the lower electrode 170 and the dielectric layer 180, and the capacitor structure CS in which the dielectric layer 180 is disposed directly on the supporter 190 and the semiconductor device 100 including the same may be formed.

According to some implementations, the amount of the first material on the surface of the supporter 190 may be 10 % or less of the amount of the first material on the surface of the lower electrode 170. Leakage current between nodes may be reduced and bridge defects may be reduced by significantly reducing an amount of the first material remaining on a surface of the supporter 190 compared to an amount of the first material remaining on a surface of the lower electrode 170.

The manufacturing process of the capacitor structure CS described with reference to FIGS. 6 to 16 is merely an example, and the present disclosure is not limited thereto, and some of the above-described manufacturing processes may be omitted or other manufacturing processes may be added.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A capacitor structure (CS) comprising:
a plurality of lower electrodes (170) positioned on a substrate (110);
a supporter (190) positioned between sidewalls of the lower electrodes (170) and extending in a direction parallel to an upper surface of the substrate (110);
an auxiliary layer (300) disposed on the plurality of lower electrodes (170);
a dielectric layer (180) disposed on the auxiliary layer (300) and the supporter (190); and
an upper electrode (200) positioned on the dielectric layer (180),
wherein the auxiliary layer (300) includes:
a first auxiliary layer (310) including a conductive first material, and
a second auxiliary layer (320) including an insulating second material.

2. The capacitor structure (CS) of claim 1, wherein
the first auxiliary layer (310) and the second auxiliary layer (320) are sequentially disposed between the plurality of lower electrodes (170) and the dielectric layer (180),
the first auxiliary layer (310) is disposed on the plurality of lower electrodes (170),
the second auxiliary layer (320) is disposed on the first auxiliary layer (310),
the dielectric layer (180) is disposed on the second auxiliary layer (320), and
the dielectric layer (180) is disposed directly on the supporter (190).

3. The semiconductor device (100) of claim 1 or 2, wherein
the plurality of lower electrodes (170), the first auxiliary layer (310), the second auxiliary layer (320), and the dielectric layer (180) are positioned in that order.

4. The capacitor structure (CS) of claim 1, wherein
the first auxiliary layer (310) and the second auxiliary layer (320) are sequentially disposed between the plurality of lower electrodes (170) and the dielectric layer (180),
the second auxiliary layer (320) is disposed on the plurality of lower electrodes (170),
the first auxiliary layer (310) is disposed on the second auxiliary layer (320),
the dielectric layer (180) is disposed on the first auxiliary layer (310), and
the dielectric layer (180) is disposed directly on the supporter (190).

5. The semiconductor device (100) of claim 1 or 4, wherein
the plurality of lower electrodes (170), the second auxiliary layer (320), the first auxiliary layer (310), and the dielectric layer (180) are positioned in that order.

6. The capacitor structure (CS) of any one of claims 1 to 5, wherein
the conductive first material includes: a first metal, an oxide of the first metal, or a nitride of the first metal.

7. The capacitor structure (CS) of any one of claims 1 to 6, wherein
the first auxiliary layer (310) further includes a third material, and
the first auxiliary layer (310) has a structure in which at least one layer including the conductive first material and at least one layer including the third material are stacked.

8. The capacitor structure (CS) of any one of claims 1 to 7, wherein
the insulating second material includes an oxide of a second metal, and
the supporter (190) includes the insulating second material.

9. The capacitor structure (CS) of any one of claims 1 to 8, wherein
an amount of the conductive first material on a surface of the supporter (190) is 10 % or less of an amount of the conductive first material on surfaces of the plurality of lower electrodes (170).

10. The capacitor structure (CS) of any one of claims 1 to 9, wherein
the second auxiliary layer (320) further includes at least one material that is different from the insulating second material, and
the second auxiliary layer (320) is a mixed layer of the insulating second material and the at least one material.

11. The semiconductor device (100) of any one of claims 1 to 10, wherein
the first auxiliary layer (310) has a multilayer structure.

12. The semiconductor device (100) of any one of claims 1 to 11, wherein
the second auxiliary layer (320) comprises a plurality of metal oxides.

13. A semiconductor device (100) comprising:
an active pattern (AC) on a substrate (110);
a gate structure (120) extending in a first direction parallel to an upper surface of the substrate (110) and buried in an upper portion of the substrate (110);
a bit line structure (130) extending in a second direction parallel to the upper surface of the substrate (110) and intersecting the active pattern (AC);
a contact plug structure (150) connected to an end portion of the active pattern (AC); and
a capacitor structure (CS) of any one of the previous claims and connected to the contact plug structure (150).

14. A manufacturing method for a capacitor structure (CS), the method comprising:
providing a supporter (190) between sidewalls of each a plurality of lower electrodes (170) positioned on a substrate (110), the supporter (190) extending in a direction parallel to an upper surface of the substrate (110);
forming a first auxiliary layer (310) including a first material covering surfaces of the plurality of lower electrodes (170) and the supporter (190);
forming a second auxiliary layer (320) including a second material on the first auxiliary layer (310);
performing a heat treatment on a structure on which the second auxiliary layer (320) is formed;
selectively removing a portion of the first auxiliary layer (310) and a portion of the second auxiliary layer (320) positioned on the supporter (190) by etching the first material; and
depositing a dielectric layer (180),
wherein the first auxiliary layer (310) and the second auxiliary layer (320) are disposed between the plurality of lower electrodes (170) and the dielectric layer (180), and the dielectric layer (180) is disposed directly on the supporter (190).
